(19) Europäisches Patentamt

European Patent Office

Office européen des brevets

(11) EP 1 394 820 A2

(12) EUROPEAN PATENT APPLICATION

(43) Date of publication:
03.03.2004 Bulletin 2004/10

(51) Int Cl.$^7$: H01F 1/28

(21) Application number: 03019759.4

(22) Date of filing: 29.08.2003

(84) Designated Contracting States:
AT BE BG CH CY CZ DE DK EE ES FI FR GB GR HU IE IT LI LU MC NL PT RO SE SI SK TR
Designated Extension States:
AL LT LV MK

(30) Priority: 30.08.2002 JP 2002252351

(71) Applicant: Nec Tokin Corporation
Sendai-shi, Miyagi (JP)

(72) Inventors:
• Yoshida, Shigeyoshi
  Taihaku-ku, Sendai-shi, Miyagi (JP)
• Andoh, Shinsuke
  Taihaku-ku, Sendai-shi, Miyagi (JP)
• Ono, Hiroshi
  Taihaku-ku, Sendai-shi, Miyagi (JP)

(74) Representative: Hofer, Dorothea, Dr. et al
Harthauser Strasse 25d
81545 München (DE)

(54) **Magnetic loss material and method of producing the same**

(57) A magnetic loss material includes a soft magnetic powder and a binder. In the magnetic loss material, a frequency dispersion profile of an imaginary part magnetic permeability ($\mu''$) has at least two different dispersion portions including a first dispersion portion (D1) at a relatively high-frequency side and a second dispersion portion (D2) at a relatively low frequency side. The imaginary part magnetic permeability has first and second maximum values ($\mu''_{max}$ (D1) and $\mu''_{max}$ (D2)) as the maxima within the first and the second dispersion portions, respectively. The second maximum value is equal to or greater than the first maximum value. The second dispersion portion may be the dispersion owing to magnetic resonance. The first dispersion portion may be the dispersion owing to eddy current.

FIG. 3B

EP 1 394 820 A2

**Description**

The present application claims priority to prior Japanese patent application JP 2002-252351, the disclosure of which is incorporated herein by reference.

Background of the Invention:

The present invention relates to a magnetic loss material that is excellent in magnetic loss characteristic at high frequencies, and further relates to a method of producing the magnetic loss material.

In recent years, the spread of highly integrated semiconductor devices operated at high speeds has been remarkable. As examples thereof, there have been logic circuit elements or active elements, such as random access memories (RAMs), read only memories (ROMs), microprocessor units (MPUs), central processing units (CPUs), and image processor arithmetic logic units (IPALUs). In these active elements, the calculation speeds or the signal processing speeds have been rapidly increased. In this case, electrical signals propagating in electronic circuits cause large fluctuation in voltage and current, and therefore, inductive high-frequency radiated noise is liable to occur as unwanted radiation.

On the other hand, reduction in weight, thickness and size of electronic components and devices has also been rapidly advanced. Following it, the degrees of integration of semiconductor devices and the mounting densities of electronic components onto printed wiring boards have also been extremely enhanced. Therefore, excessively integrated or mounted electronic elements or signal lines are located very close to each other. In combination with the above-mentioned increase in signal processing speeds, the high-frequency radiated noise become more liable to be induced.

In recent years, in such electronic integrated elements or wiring boards, a countermeasure has been taken, for example, by inserting a lumped constant component such as a decoupling capacitor in the transmissicn fine. However, in the higher-speed electronic integrated elements or wiring toards, the generated noise includes harmonic components so that a signal path tends to behave as a distributed-constant circuit. As a consequence the conventional noise countermeasure assuming a lumped constant circuit does not work effectively.

Recently, the inventors have enabled to use a magnetic loss material which exhibits a large magnetic loss in a high-frequency region. By disposing the magnetic loss material in the neighborhood of an unwanted radiation source, it is possible to effectively suppress unwanted radiation generated from a semiconductor device, an electronic circuit, or the like, through suppressing a conducted noise between noise source and radiation source. With respect to a mechanism of unwanted radiation attenuation utilizing such a magnetic loss, recent studies have shown that an equivalent resistance component is given to the electronic circuit as the unwanted radiation source. Here, a magnitude of the equivalent resistance component depends on a magnitude of an imaginary part magnetic permeability $\mu''$, and a frequency region where a noise suppression effect takes place depends on a frequency dispersion of the imaginary part magnetic permeability $\mu''$. Therefore, in order to achieve greater attenuation of unwanted radiation, a large value of the imaginary part magnetic permeability $\mu''$ and the frequency dispersion of $\mu''$ matching v/ith the frequency distribution of the unwanted radiation are required.

In most cases, however, the frequency distribution of unwanted radiation actually generated in various electronic circuits spreads over a wide range and, therefore, can not sufficiently be covered by a steep frequency dispersion of $\mu''$ owing to magnetic resonance as observed in a typical magnetic material. Further, the gentle magnetic permeability dispersion owing to an eddy current loss can not provide a sufficient magnitude of $\mu''$ and, therefore, a large noise suppression effect can not be expected.

Summary of the Invention:

It is therefore an object of the present invention to provide a magnetic loss material that is effective against unwanted radiation from an active element, an electronic circuit or the like that is operated at high speed.

It is another object of the present invention to provide a magnetic loss material that can easily and effectively suppress unwanted radiation spreading over a wide frequency band.

It is another object of the present invention to provide a magnetic loss material that can effectively suppress a noise component without affecting a signal component.

It is still another object of the present invention to provide a method of producing the above-mentioned magnetic loss material.

The present inventors have made extensive and quantitative studies to analyze a phenomenon that a resistance component is added to a transmission line when a magnetic material with a magnetic loss is placed close to the transmission line. As a result, it has been found out that a magnitude of a suppression effect against conducted noise is substantially proportional to an imaginary part permeance ($\mu''\cdot\delta$), which is the product of an imaginary part magnetic

permeability $\mu''$ and a magnetization depth $\delta$, and a frequency f. Accordingly, the present inventors have conceived that, if a magnetic material has a frequency dispersion profile of $\mu''$ that steeply rises and then gradually decreases or that steeply rises and exhibits a large dispersion over a wide frequency band, it is then possible to realize a lossy low-pass filter characteristic and a band-eliminated filter characteristic that cause a sharp change in equivalent resistance at a specific cut-off frequency. Thus, the present invention has been made.

In order to evaluate the conducted noise suppression effect, it will be helpful to consider the loss characteristic $P_{loss}$, as will later be described in detail. The higher the frequency is, the loss characteristic decreases slowly in response to reduction of the imaginary part magnetic permeability $\mu''$. In order to attain the object of the present invention, the frequency dispersion of the imaginary part magnetic permeability $\mu''$ must steeply rise. If the frequency dispersion of the imaginary part magnetic permeability $\mu''$ decreases gently after the steep rise, the loss can be maintained at a high level because of the above-mentioned loss characteristic so that the excellent low-pass filter can be constituted. Moreover, in case of the profile which steeply rises and rapidly decreases thereafter, the excellent low-pass filter and the excellent band-eliminated filter can be obtained by designing the profile exhibiting a large dispersion over a wide frequency band.

In order to achieve the profile in which the dispersion of the imaginary part magnetic permeability $\mu''$ rises steeply and decreases gently thereafter, the spread of the dispersion must be asymmetrical. Specifically, the dispersion must be narrow at a low frequency side and must be wide at a high-frequency side. However, it is very difficult to realize such asymmetrical dispersion by a single mechanism of permeability relaxation.

As an example of the dispersion asymmetrical on a frequency axis, consideration will be made about a single sheet of magnetic thin film. In this case, the gentle dispersion owing to eddy current circulation appears first (i.e., at a low frequency side) and the steep dispersion owing to magnetic resonance appears thereafter (i.e., at a high-frequency side). As a result, the profile in which $\mu''$ gently rises and steeply decreases is obtained.

Thus, the profile typically observed is related to both of the eddy current and the magnetic resonance and includes the dispersion owing to the eddy current circulation at the low frequency side and the dispersion owing to the magnetic resonance at the high-frequency side. Such typical profile is different in required performance from the profile as a goal of the present invention, i.e., the profile which rises steeply and decreases gently thereafter. Therefore, the typical profile is not desirable in noise protection which aims at effectively suppressing a noise component without affecting a signal component in case where the signal component and the noise component are close to each other.

In view of the foregoing, according to this invention, a magnetic loss material is given two magnetic losses appearing in different frequency regions so that a magnetic loss material exhibiting a dispersion profile of an imaginary part magnetic permeability $\mu''$ that steeply rises and thereafter gently decreases or that steeply rises and exhibits a large dispersion over a wide frequency band.

According to an aspect of the present invention, there is provided a magnetic loss material comprising a soft magnetic powder and a binder binding the particles of the powder to one another, the magnetic loss material having a frequency dispersion profile of an imaginary part magnetic permeability ($\mu''$), wherein the frequency dispersion profile comprises at least two different dispersion portions including a first dispersion portion (D1) at a relatively high-frequency side and a second dispersion portion (D2) at a relatively low-frequency side, the imaginary part magnetic permeability ($\mu''$) having a first maximum value ($\mu''_{max}(D1)$) that is the maximum within the first dispersion portion (D1) and a second maximum value ($\mu''_{max}(D2)$) that is the maximum within the second dispersion portion (D2), the second maximum value ($\mu''_{max}(D2)$) being equal to or greater than the first maximum value ($\mu''_{max}(D1)$).

According to another aspect of the present invention, there is provided a method of producing a magnetic loss material in which a frequency dispersion profile of an imaginary part magnetic permeability ($\mu''$) has first and second dispersion portions (D1 and D2) having mutually different dispersion frequency regions, the second dispersion portion (D2) at a low-frequency side being a dispersion owing to magnetic resonance, the method comprising preparing soft magnetic powder of an indefinite shape having a thickness or a diameter which is greater than a skin depth, grinding the soft magnetic powder to obtain hybrid soft magnetic powder comprising a first particle group and a second particle group each of which contains powder particles of an irregular shape or a flat shape, the powder particles in the first particle group having a thickness or a diameter which is greater than the skin depth, the powder particles in the second particle group having a thickness or a diameter which is smaller than the skin depth, mixing a binder including a high molecular compound into the hybrid soft magnetic powder to obtain a mixture thereof, and molding the mixture.

Brief Description of the Drawings:

Fig. 1 is a diagram showing an example wherein a magnetic loss material is disposed close to a transmission line through which unwanted high-frequency current flows;

Figs. 2A and 2B are diagrams showing equivalent circuits of the distributed constant line before and after the magnetic loss material is disposed, respectively;

Fig. 3A is a diagram showing an ideal frequency characteristic of an equivalent resistance component R necessary for noise separation;

Fig. 3B is a diagram showing an ideal frequency characteristic profile of an imaginary part magnetic permeability $\mu''$ of the magnetic loss material;

Fig. 4 is a scanning electron microscope photograph of a powder sample;

Fig. 5 is a diagram showing a thickness distribution of the powder sample and a skin depth $\delta_s$ of the powder sample;

Fig. 6 is a diagram showing an evaluation system for inspecting a conducted noise suppression effect;

Fig. 7 is a $\mu$-f characteristic diagram of a sample of embodiment 1 of the present invention;

Fig. 8 is a $\mu$-f characteristic diagram of a sample of embodiment 2 of the present invention;

Fig. 9 is a $\mu$-f characteristic diagram of a sample of embodiment 3 of the present invention;

Fig. 10 is a $\mu$-f characteristic diagram of a sample of embodiment 4 of the present invention;

Fig. 11 is a $\mu$-f characteristic diagram of a sample of embodiment 5 of the present invention;

Fig. 12 is a $\mu$-f characteristic diagram of a sample of embodiment 6 of the present invention;

Fig. 13 is a $\mu$-f characteristic diagram of a sample of embodiment 7 of the present invention;

Fig. 14 is a $\mu$-f characteristic diagram of a sample of comparative example 1;

Fig. 15 is a $\mu$-f characteristic diagram of a sample of comparative example 2;

Fig. 16 is a $\mu$-f characteristic diagram of a sample of comparative example 3;

Fig. 17 is a diagram showing a frequency-dependent characteristic of $P_{loss}$ of the sample of embodiment 1;

Fig. 18 is a diagram showing a frequency-dependent characteristic of $P_{loss}$ of the sample of embodiment 2;

Fig. 19 is a diagram showing a frequency-dependent characteristic of $P_{loss}$ of the sample of embodiment 3;

Fig. 20 is a diagram showing a frequency-dependent characteristic of $P_{loss}$ of the sample of embodiment 4;

Fig. 21 is a diagram showing a frequency-dependent characteristic of $P_{loss}$ of the sample of embodiment 5;

Fig. 22 is a diagram showing a frequency-dependent characteristic of $P_{loss}$ of the sample of embodiment 6;

Fig. 23 is a diagram showing a frequency-dependent characteristic of $P_{loss}$ of the sample of embodiment 7;

Fig. 24 is a diagram showing a frequency-dependent characteristic of $P_{loss}$ of the sample of comparative example 1;

Fig. 25 is a diagram showing a frequency-dependent characteristic of $P_{loss}$ of the sample of comparative example 2; and

Fig. 26 is a diagram showing a frequency-dependent characteristic of $P_{loss}$ of the sample of comparative example 3.

Description of the Preferred Embodiments:

With reference to the drawing, description will be given about a magnetic loss material and a method of producing the same according to a preferred embodiment of the present invention.

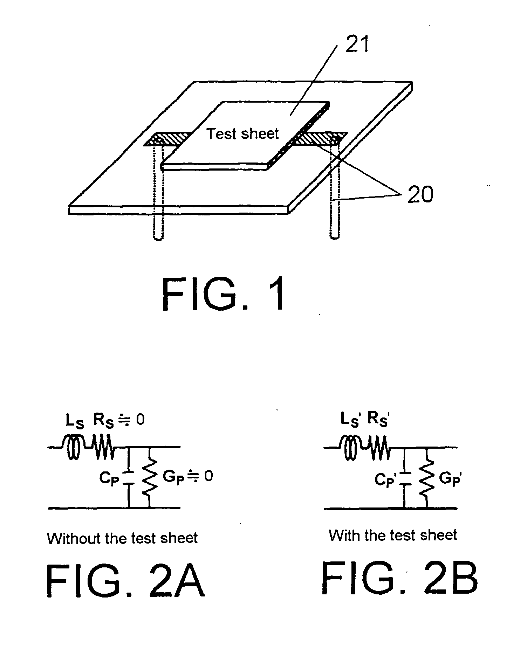

Referring to Fig. 1, a magnetic loss material 21 as a test sheet is disposed close to a transmission line 20 where electromagnetic noise conducts, i.e. unwanted high-frequency current flows. In this event, the transmission line 20 and the magnetic loss material 21 are inductively coupled. As a result, the transmission line 20 is given an equivalent resistance having frequency selectivity so that an equivalent circuit of the transmission line shown in Fig. 2A is changed to that shown in Fig. 2B. Here, the magnitude of the equivalent resistance given to the transmission line 20 by the magnetic loss material 21 depends on the product ($=\mu''\cdot f$) of an imaginary part magnetic permeability $\mu''$ of the magnetic loss material 21 and a frequency f.

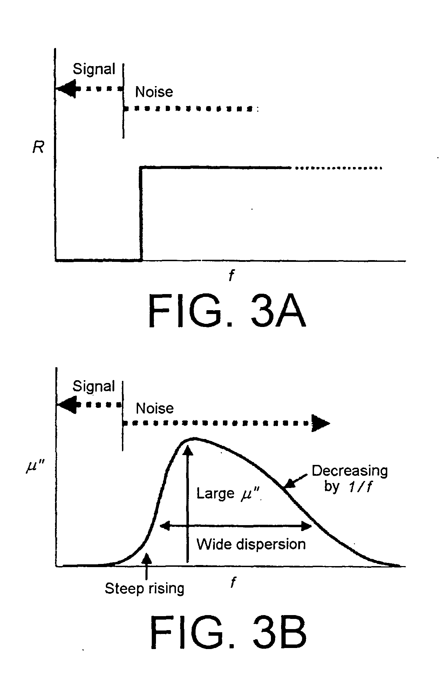

As shown in Fig. 3A, it is preferable that a resistance R given to the transmission line is approximately equal to zero in a signal frequency region (Signal) while the resistance R given to the transmission line is large in a noise frequency region (Noise).

In order to achieve the object of the present invention, the frequency dispersion of the imaginary part magnetic permeability $\mu''$ must steeply rise. Since, the higher the frequency is, the loss characteristic $P_{loss}$ decreases slowly in response to reduction of the imaginary part magnetic permeability $\mu''$, if the frequency dispersion of the imaginary part magnetic permeability $\mu''$ decreases gently after the steep rise, the loss can be maintained at a high level so that the excellent low-pass filter can be constituted. Moreover, in case of the profile which steeply rises and rapidly decreases thereafter, the excellent low-pass filter and the excellent band-eliminated filter can be obtained by designing a profile exhibiting the large dispersion over a wide frequency band.

Thus, as shown in Fig. 3B, an ideal dispersion profile of the imaginary part magnetic permeability $\mu''$ rises steeply in response to the rise of frequency and decreases gently thereafter. Moreover, although not illustrated in the figure, large dispersion over a wide frequency band provides excellent characteristics in case of the profile rising steeply and decreasing rapidly thereafter.

In view of the foregoing, the frequency characteristic of the magnetic loss material is given two different dispersion portions, i.e., first and second dispersion portions D1 and D2 having mutually different frequency regions to thereby achieve the dispersion profile of the imaginary part magnetic permeability that steeply rises and thereafter gently decreases.

In order to obtain the two dispersion portions in the frequency characteristic of the imaginary part magnetic permeability of the magnetic loss material, several approaches are available as described hereinbelow. The principles of those methods are disclosed in, for example, JP-A-H09-35927 and J P-A-2001-21510.

As one approach, two magnetic powder groups different in frequency dispersion region are mixed. As another approach, two magnetic powder groups different in frequency dispersion region from each other are prepared from one starting material by mechanical processing or the like. As a still another approach, two frequency dispersion portions are achieved by a single kind of powder.

Description will be made about a first method which is developed from the above-mentioned approaches and which is intended to realize an ideal dispersion profile having two dispersion portions in the frequency characteristic of the imaginary part magnetic permeability. Those mechanisms which cause a magnetic material to exhibit a magnetic loss include a mechanism based on eddy current circulation and another mechanism based on magnetic resonance (also called ferromagnetic resonance or natural resonance). The eddy current produced in the magnetic material depends upon the thickness, the electric resistance, the magnetic permeability, and the frequency. On the other hand, the magnetic resonance greatly depends upon an anisotropic magnetic field Hk of the magnetic material. Generally, the dispersion of the imaginary part magnetic permeability owing to the magnetic resonance gives a steep change in imaginary part magnetic permeability as compared with the dispersion owing to the eddy current.

Therefore, dispersion of the imaginary part magnetic permeability which rises steeply in response to the increase in frequency and thereafter decreases gently can be realized if a magnetic material (magnetic powder) which exhibits magnetic resonance at a relatively low frequency and another magnetic material (magnetic powder) which causes permeability relaxation owing to the eddy current at a relatively high frequency are mixed together at an appropriate ratio.

Furthermore, in order to obtain a dispersion profile of the imaginary part magnetic permeability which rises steeply and exhibits a large dispersion over a wide frequency band, magnetic materials (magnetic powder) whose dispersions owing to the magnetic resonance are separated from each other by a desired frequency bandwidth are mixed together at an appropriate ratio.

Now, a second method will be described. In order to cause the magnetic resonance mentioned above, it is premised that no substantial eddy current flows in a frequency range lower than a frequency at which the magnetic resonance appears. Consideration will be made of powder with a single common composition and a wide particle size distribution. If a skin depth ($\delta_s$) giving a criterion of eddy current circulation falls within a range of the particle size distribution in a frequency region lower than the frequency at which the magnetic resonance is expected, the powder group in which the particle size is greater than the skin depth exhibits permeability relaxation owing to the eddy current at a frequency lower than the frequency at which the magnetic resonance is caused.

By utilizing the above-mentioned relationship between the size of the magnetic powder and the skin depth, the dispersion of the imaginary part magnetic permeability that steeply rises and thereafter gently decreases can be obtained by the use of the powder having a single common composition. Particularly, in case where starting material powder is magnetic metal powder that is relatively brittle and when the powder is supplied to an agitated media mill such as a ball mill, relatively large powder is partly broken off to become fine powder. The fine powder is flattened under shearing stress of the media. As a result, the fine powder is further reduced in thickness. Thus, a thickness distribution of the powder is widened and may be separated into two thickness groups.

In case where generation of the eddy current circulating inside the powder is observed within a wide and dual distribution of the powder thickness, the large powder contributes to gentle magnetic permeability dispersion owing to the eddy current while the thin flat powder contributes to steep magnetic permeability dispersion owing to the magnetic resonance. Therefore, one kind of starting material powder with the single common composition provides the imaginary part magnetic permeability having a dispersion profile comprising a first dispersion portion D1 at the high-frequency side owing to the eddy current and a second dispersion portion D2 at the low-frequency side owing to the magnetic resonance.

Now, a third method will be described. Even if the powder has a substantially uniform composition and a monotonous particle size distribution, two magnetic resonances may possibly take place. Presumably, this phenomenon is caused by surface magnetic anisotropy which will be observed in the magnetic powder having a non-zero magnetostrictive constant when the surface area of the powder reaches a certain extent. For example, the magnetic powder having a non-zero magnetostrictive constant may be $Fe_3O_4$ (magnetite) or fine flat metal powder changed in composition under the shear stress by a ball mill and, as a result, given a non-zero magnetostrictive constant. Such phenomenon is described in detail by the present inventors in JP-A-2001-210510 and in S. Yoshida et al article, J. Appl. Phys., 85, 8, 4636 (1999).

With respect to the occurrence of the two magnetic resonances presumably caused by the surface magnetic anisotropy, the surface area per powder unit weight is a predominant factor. However, since the surface area that causes the two resonances is also dependent upon other factors that bring about the surface magnetic anisotropy, for example, the magnitude of a magnetoelastic effect, i.e. the magnitude of a magnetostrictive constant, and a magnitude of residual stress of.the powder, it is difficult to specify the value of the surface area in question.

There is a tendency in which two resonances are generated in the soft magnetic powder having a specific surface area of 0.3m$^2$/g or more. However, the above-mentioned powder provides no more than a dispersion profile showing a gentle dispersion at a low frequency side and a steep dispersion at a high-frequency side. By the recent studies, however, It has been found out that the dispersion profile steeply rises at a low frequency side is obtained by a very narrow range of the specific surface area and heat treatment of the powder. The object of this invention can be achieved thereby.

In the foregoing, description has been given about the three methods for obtaining such a dispersion profile in which the imaginary part magnetic permeability steeply rises with the increase in frequency and thereafter gently decreases or a dispersion profile in which the imaginary part magnetic permeability steeply rises and exhibits a large dispersion over a wide frequency band. Depending upon physical properties of magnetic powder to be used as a raw material and a targeted dispersion frequency region of the imaginary part magnetic permeability, the optimum method may be selected.

In each of the first to the third methods, it is necessary that the imaginary part magnetic permeability $\mu''$ has a first maximum values $\mu''_{max}$ (D1) that is the maximum within the first dispersion portion D1 and a second maximum value $\mu''_{max}$ (D2) that is the maximum within the second dispersion portion D2 and the second maximum value $\mu''_{max}$ (D2) is equal to or greater than the first maximum value $\mu''_{max}$ (D1). Preferably, either of the relationships of $\Delta fr'' \leq D1_{50}$ or $\Delta fr'' \leq D2_{50}$ is established where $\Delta fr''$ represents a difference between frequencies $fr''_{max}$ (D1) and $fr''_{max}$ (D2). Wherein $fr''_{max}$ (D1) represents the frequency where the imaginary part magnetic permeability $\mu''$ has a first maximum value $\mu''_{max}$ (D1) and $fr''_{max}$ (D2) represents the frequency where the imaginary part magnetic permeability $\mu''$ has a second maximum value $\mu''_{max}$ (D2), $D1_{50}$ represents a full width half maximum of the first dispersion portion D1, and $D2_{50}$ represents a full width half maximum of the second dispersion portion D2.

Now, description will be made in detail as regards several embodiments of the present invention. In each of the embodiments, use is made of a soft magnetic powder which includes first through (n+1)-th powders, where n is an integer not smaller than one. The first and the (n+1)-th powders are different from each other in any one of the composition, the particle size, or the particle shape and are mixed together into the soft magnetic powder.

At first, the first method will be described in conjunction with the case where n = 1. Specifically, two kinds of soft magnetic powder are used. Although the embodiment of n = 1 is described herein, the value of n may be 2 (embodiment using three kinds of soft magnetic powder), 3 (embodiment using four kinds of soft magnetic powder), and so on as far as a desired characteristic and a desired profile can be obtained.

(Embodiment 1)

First, the following soft magnetic powders a and b were prepared.

a: flat iron-aluminum-silicon alloy powder having an average particle size in longitude axis of 45μm used iron-aluminum-silicon (10wt% Si - 6wt% Al- the balance Fe) alloy powder produced by a water atomizing method and having a teardrop shape and an average particle size of 50μm as a raw material and processed by the wet-attrition.;

b: flat iron-aluminum-silicon alloy powder having an average particle size in longitude axis of 12μm used iron-aluminum-silicon (10wt% Si - 6wt% Al- the balance Fe) alloy powder produced by a water atomizing method and having a teardrop shape and an average particle size of 20μm as a raw material and processed by the wet-attrition.

After annealing these two powders in an Ar gas atmosphere at 650°C for three hours, a soft magnetic paste was prepared with a composition shown in Table 1 and formed into a film by a doctor blade method. The film was then subjected to hot press and thereafter cured at 85°C for 24 hours. Thus, a magnetic loss material was obtained as a sample of the embodiment 1.

Table 1

| component | mixing ratio |
|---|---|
| flat iron-aluminum-silicon alloy powder a | 60wt. parts |
| flat iron-aluminum-silicon alloy powder b | 40wt. parts |
| chlorinated polyethylene resin | 10wt. parts |
| solvent (toluene) | 50wt. parts |
| total | 160wt. parts |

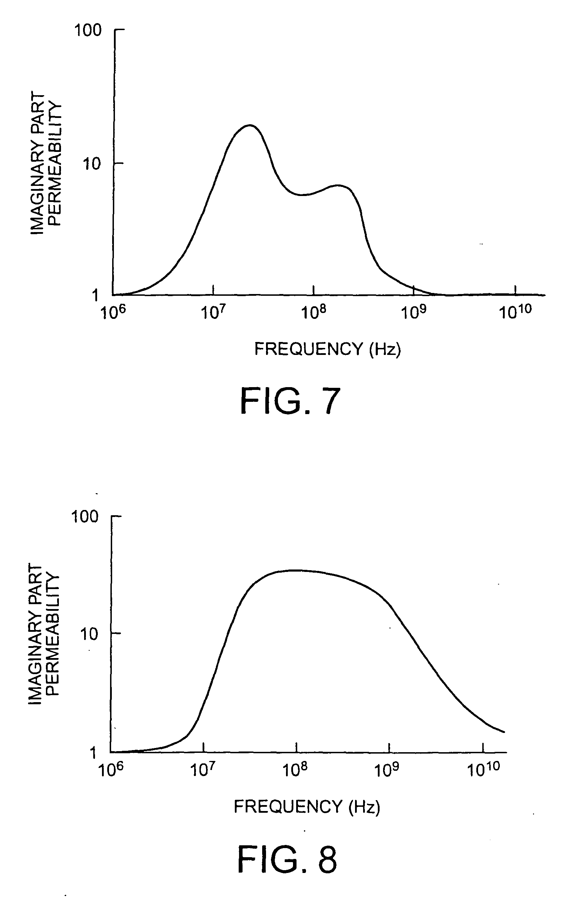

At this time, the dispersion resulting from the powder a is D2. The value of $fr''_{maX}$ (D2) is 26MHz and the full width half maximum $D2_{50}$ is 35MHz. On the other hand, the dispersion resulting from the powder b is D1. The value of $fr''_{max}$ (D1) is 161 MHz and the full width half maximum $D1_{50}$ is 320MHz. These two powders satisfy the relationship given by $fr''_{max}(D1) > fr''_{max}(D2)$ and the relationship $\mu''_{max} 1 < \mu''_{max}2$, as seen from Fig. 7. Furthermore, since the difference $\Delta fr'' = fr''_{max}(D1) - fr''_{max}(D2)$ is 135MHz, it will be understood that the relationship $\Delta fr'' \leqq D1_{50}$ is satisfied. In this embodiment, the relationship shows $\Delta fr'' > D2_{50}$. It is argued here on the supposition that the relationship $\Delta fr'' \leqq D1_{50}$ is also not satisfied, i.e., the relationship shows $\Delta fr'' > D1_{50}$ and $\Delta fr'' > D2_{50}$. In this event, the $\mu$-f characteristic has a valley between D1 and D2 and the $P_{loss}$ characteristic indicates that the noise is allowed to pass. In this embodiment, the above-mentioned relationship $\Delta fr'' \leqq D1_{50}$ is satisfied so that the valley will not be produced. Therefore, a desired attenuation characteristic is achieved.

(Embodiment 2)

Soft magnetic powders c and d were prepared.

c: nickel-iron (84wt% Ni - 16wt% Fe) alloy powder produced by a water atomizing method and having a teardrop shape and an average particle size of ave 20μm;
d: flat iron-aluminum-silicon alloy powder obtained by preparing, as a starting material, water atomized iron-aluminum-silicon (10wt% Si - 6wt% Al - the balance Fe) alloy powder having an average particle size of 30μm, and wet grinding the alloy powder by the use of an attoritor. The powder d was annealed in an Ar gas atmosphere at 650 °C for three hours.

These two powders were mixed to prepare a paste which was formed into a film by a doctor blade method. The film was then subjected to hot pressing and thereafter cured at 85°C for 24 hours. Thus, a magnetic loss material was obtained as a sample of the embodiment 2.

Table 2

| component | mixing ratio |
|---|---|
| teardrop-shaped nickel-iron alloy powder c | 20wt. parts |
| flat iron-aluminum-silicon alloy powder d | 80wt. parts |
| chlorinated polyethylene resin | 10wt. parts |
| solvent (toluene) | 50wt. parts |
| total | 160wt. parts |

The second method will be described.

(Embodiment 3)

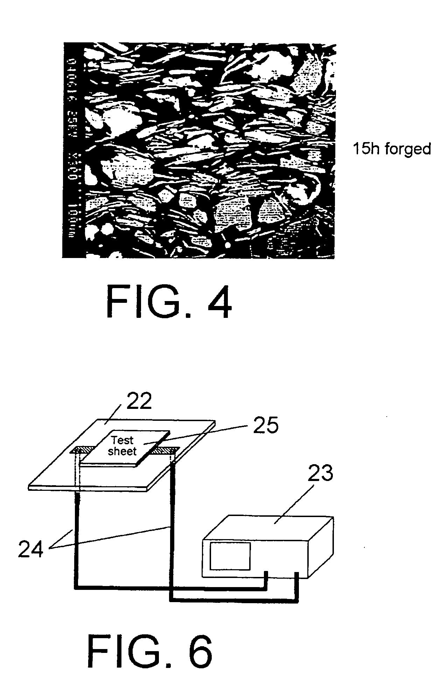

Iron-aluminum-silicon alloy ingot (10wt% Si 6wt% Al - the balance Fe) was prepared as starting material powder and subjected to stamp-mill grinding to thereby obtain coarse powder of an irregular shape having an average particle size of 40μm. The iron-aluminum-silicon coarse powder having an irregular shape was supplied to a sand grinding mill together with n-hexane. The coarse powder was ground for 15 hours to obtain a powder sample e. A scanning electron microscope photograph of the powder sample e is shown in Fig. 4. By the use of the powder e and with the ratio shown in Table 3, the magnetic loss material was obtained as a sample of the third embodiment.

Table 3

| component | mixing ratio |
|---|---|
| flat iron-aluminum-silicon alloy powder e | 100wt. parts |
| chlorinated polyethylene resin | 10wt. parts |
| solvent (toluene) | 50wt. parts |
| total | 160wt. parts |

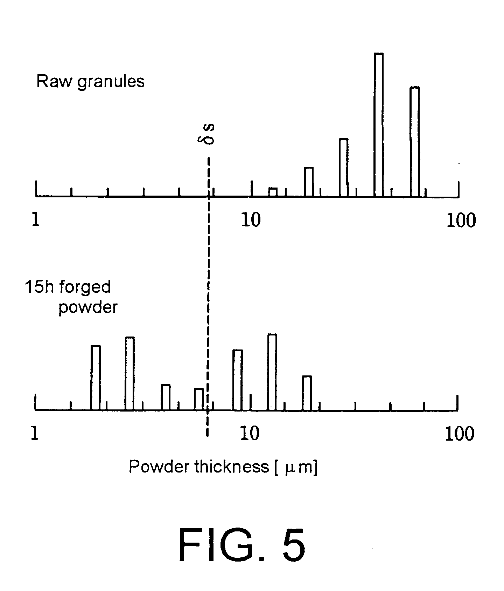

Fig. 5 shows a distribution of a thickness of the above-mentioned powder and the skin depth $\delta_s$ thereof after

grinding for 15 hours. For the thickness, the powder was sampled by random sampling and the thickness was measured by an electron microscope photograph at several points to examine the distribution. The skin depth $\delta_s$ is obtained by the following formula.

$$\delta_s = \sqrt{\frac{\rho}{\pi f \mu}} \qquad [\mu m]$$

$$\mu = \mu_0 \cdot \mu_{ip} = 4\pi \times 10^{-7} \times \frac{1}{2}\mu_{eff}$$

Herein, $\rho$ represents an electric resistance [$\Omega$m], f, a frequency [Hz], $\mu_{eff}$, magnetic permeability. At the frequency f = 100MHz, the powder e had the magnetic permeability $\mu_{eff}$ = 17 and the electric resistance $\rho$ = 9.0 x $10^{-7}$ $\Omega$·m. At this time, $\delta_s$ = 8.2 $\mu$m.

From Fig. 4 and 5, it is understood that the powder e has powder thickness distribution comprising two groups including the powder group similar in shape to the starting material coarse powder and the powder group of flat powder particles and the skin depth $\delta_s$ exists within the range of the powder thickness distribution.

The third method will be described.

(Embodiment 4)

Iron-aluminum-silicon alloy ingot (9.4wt% Si - 5.3wt% Al - the balance Fe) containing a greater ratio of iron as compared with the Sendust composition (9.6wt% Si - 5.4wt% Al - the balance Fe) and having a positive magnetostrictive constant was prepared as starting material powder. The starting material powder was subjected to stamp-mill grinding to thereby obtain coarse powder of an irregular shape having an average particle size of 40$\mu$m. The resultant iron-aluminum-silicon alloy coarse powder of an irregular shape was put into a sand grinding mill together with n-hexane. The coarse powder was ground for 40 hours to obtain flat powder f having a B.E.T. specific surface area of 8.6m$^2$/g.

After annealing the powder f in an Ar gas atmosphere at 650°C for three hours, a soft magnetic paste was prepared with a composition shown in Table 4 and was formed into a film by a doctor blade method. The film was then subjected to hot pressing and thereafter cured at 85°C for 24 hours. Thus, a magnetic loss material was obtained as a sample of the embodiment 4.

Table 4

| component | mixing ratio |
| --- | --- |
| flat iron-aluminum-silicon alloy powder f | 100wt. parts |
| chlorinated polyethylene resin | 10wt. parts |
| solvent (toluene) | 50wt. parts |
| total | 160wt. parts |

(Embodiment 5)

Similar stating material was put into a sand grinding mill together with n-hexane and ground for 60 hours to obtain fine flat powder g having a B.E.T. specific surface area of 1.53m$^2$/g.

After annealing the powder g in an Ar gas atmosphere at 650°C for three hours, a soft magnetic paste was prepared with a composition shown in Table 5 and formed into a film by a doctor blade method. The film was then subjected to hot pressing and thereafter cured at 85°C for 24 hours. Thus, a magnetic loss material was obtained as a sample of the embodiment 5.

Table 5

| component | mixing ratio |
| --- | --- |
| flat iron-aluminum-silicon alloy powder g | 100wt. parts |
| chlorinated polyethylene resin | 10wt. parts |

Table 5   (continued)

| component | mixing ratio |
|---|---|
| solvent (toluene) | 50wt. parts |
| total | 160wt. parts |

(Embodiment 6)

Nickel-iron alloy ingot (77wt% Ni - 23wt% Fe) containing a greater ratio of iron than a Permalloy composition (80wt% Ni - 20wt% Fe) and having a positive magnetostrictive constant was prepared as starting material powder and subjected to stamp-mill grinding to thereby obtain coarse powder of an irregular shape having an average particle size of 25μm. The nickel-iron alloy coarse powder of an irregular shape was put into a sand grinding mill together with n-hexane and ground for 8 hours to obtain fine flat powder h having a B.E.T. specific surface area of 0.39m$^2$/g.

By the use of the powder h, a soft magnetic paste was prepared with a composition shown in Table 6 and formed into a film by a doctor blade method. The film was then subjected to hot pressing and thereafter cured at 85°C for 24 hours. Thus, a magnetic loss material was obtained as a sample of the embodiment 6.

Table 6

| component | mixing ratio |
|---|---|
| flat nickel-iron alloy powder h | 100wt. parts |
| chlorinated polyethylene resin | 10wt. parts |
| solvent (toluene) | 50wt. parts |
| total | 160wt. parts |

(Embodiment 7)

By the use of Fe$_3$O$_4$ (Magnetite) powder i having a B.E.T. specific surface area of 1.97m$^2$/g, a soft magnetic paste was prepared with a composition shown in Table 7 and formed into a film by a doctor blade method. The film was then subjected to hot pressing. Thus, a magnetic loss material was obtained as a sample of the embodiment 7.

Table 7

| component | mixing ratio |
|---|---|
| magnetite powder i | 100wt. parts |
| chlorinated polyethylene resin | 10wt. parts |
| solvent (toluene) | 50wt. parts |
| total | 160wt. parts |

Hereinbelow, three comparative examples will be described.

(Comparative Example 1)

Using flat iron-silicon-aluminum alloy powder j having a Sendust composition (9.6wt% Si - 5.4wt% Al - the balance Fe) and a B.E.T. specific surface area of 0.17m$^2$/g which is relatively large, a soft magnetic paste was prepared with a composition shown in Table 8. In the manner similar to the sample of the embodiment 1, a magnetic loss material was obtained as a sample of comparative example 1.

Table 8

| component | mixing ratio |
|---|---|
| flat iron-aluminum-silicon alloy powder j | 100wt. parts |
| chlorinated polyethylene resin | 10wt. parts |

Table 8   (continued)

| component | mixing ratio |
|---|---|
| solvent (toluene) | 50wt. parts |
| total | 160wt. parts |

(Comparative Example 2)

By the use of only one of the two soft magnetic powders used in the sample of the embodiment 2, i.e., by the use of the teardrop-shaped powder a, a soft magnetic paste was prepared with a composition shown in Table 9. In the manner similar to the sample of the embodiment 1, a magnetic loss material was obtained as a sample of comparative example 2.

Table 9

| component | mixing ratio |
|---|---|
| teardrop-shaped nickel-iron alloy powder c | 100wt. parts |
| chlorinated polyethylene resin | 10wt. parts |
| solvent (mixture of cyclohexanone and toluene) | 50wt. parts |
| total | 160wt. parts |

(Comparative Example 3)

Flat iron-aluminum-silicon alloy powder k having a Sendust composition (9.6wt% Si - 5.4wt% Al - the balance Fe) and a B.E.T. specific surface area of $0.8m^2/g$ was obtained. The powder k was not subjected to annealing. Using the powder k, a soft magnetic paste was prepared with a composition shown in Table 10. In the manner similar to the sample of the embodiment 1, a magnetic loss material was obtained as a sample of comparative example 3.

Table 10

| component | mixing ratio |
|---|---|
| flat iron-aluminum-silicon alloy powder k | 100wt. parts |
| chlorinated polyethylene resin | 10wt. parts |
| solvent (toluene) | 50wt. parts |
| total | 160wt. parts |

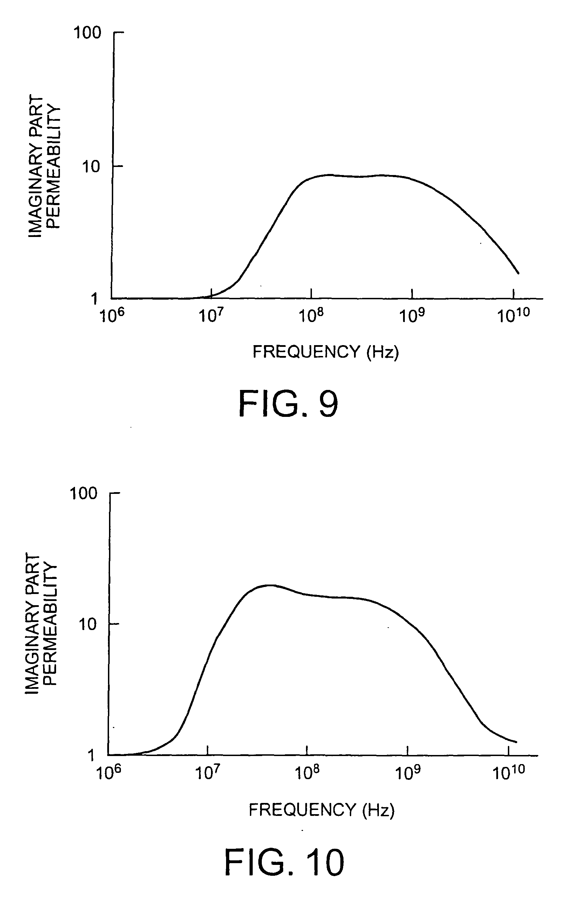

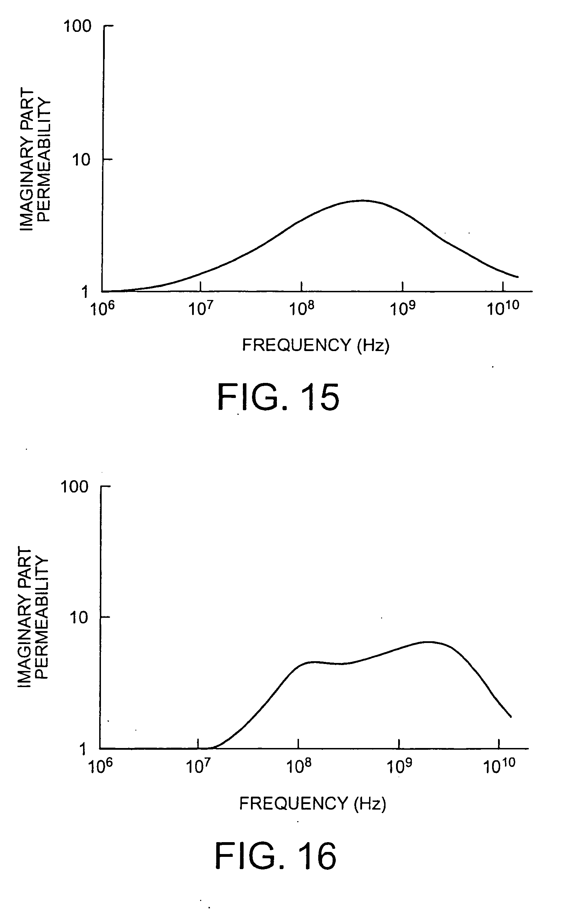

As a result of comparison between the embodiment 4 and the comparative example 3, it has been observed that these samples are similar in specific surface areas to each other but are different in dispersion profile from each other. That is, the dispersion profile of the sample subjected to annealing is different from that of the sample without annealing (see Figs. 10 and 16). Presumably, this is because if iron-silicon-aluminum alloy is annealed at a temperature higher than 500°C, crystal growth of the $DO_3$ structure is observed. In order to sufficiently grow the $DO_3$ structure, it is preferable that annealing is carried out at 650°C for about two hours. However, since high-temperature heat treatment is accompanied with a problem of excessive oxidization or combustion, annealing is preferably carried out in an inert gas atmosphere.

In order to evaluate the performance as a magnetic loss material with respect to the samples of the foregoing embodiments, a frequency-dependent characteristic of a magnetic permeability (μ-f characteristic) and a conducted noise suppression effect were examined. For measurement of the μ-f characteristic, toroidal-shaped samples of the magnetic loss material were used. By measuring the impedance to insert each sample into a test fixture forming a one-turn coil, an imaginary part magnetic permeability μ" was obtained over the frequency range from 1 MHz to 10GHz.

On the other hand, evaluation of the conducted noise suppression effect was performed using an evaluation system comprising a microstrip line 22 and a network analyzer 23 as shown in Fig. 6. In the figure, the reference numeral 24 denotes a coaxial cable. A magnetic loss material 25 having a thickness of 2mm and a size of 20mm x 20mm was used as a test sheet and placed at the center of the microstrip line 22 in close contact therewith. From transmission characteristics $S_{11}$ and $S_{21}$ in the above-mentioned condition, a loss characteristic $P_{loss}$ was obtained

using the following equation.

$$P_{loss} = 1- [(\Gamma)^2 + (T)^2]$$

Herein, $S_{11} = 20\log|\Gamma|$ and $S_{21} = 20\log|T|$. rand T represent a voltage reflection coefficient and a voltage transmission coefficient, respectively.

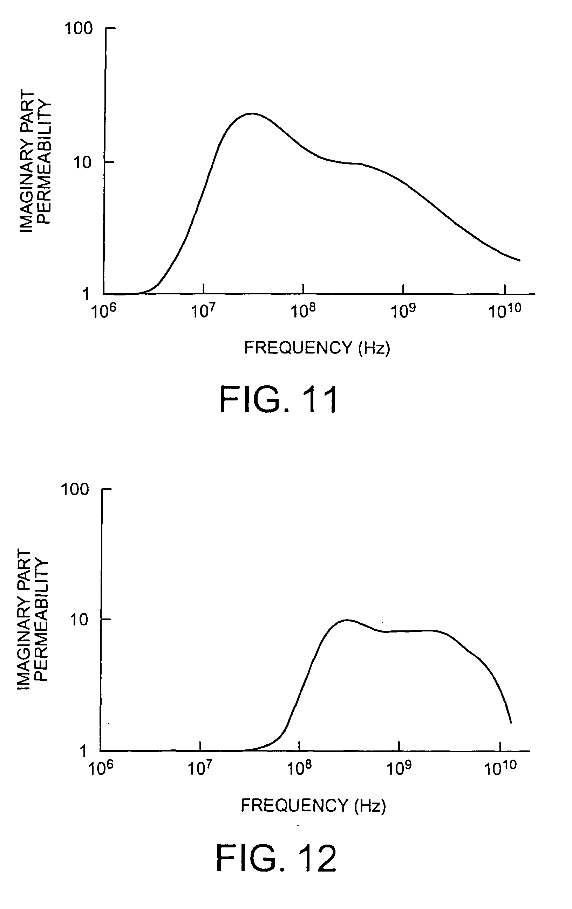

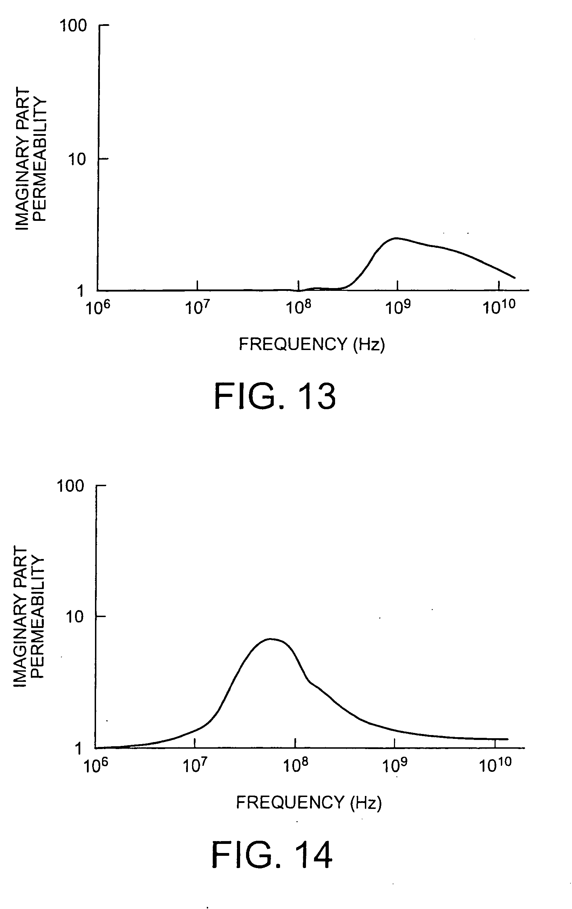

First, the $\mu$"-f characteristics of the samples of the embodiments 1 to 7 are shown in Figs. 7 to 13. The $\mu$"-f characteristics of the samples of the comparative examples 1 to 3 are shown in Figs. 14 to 16. In the $\mu$"-f characteristics of the samples of the embodiments, each sample exhibited a dispersion profile of an imaginary part magnetic permeability that steeply rises and thereafter gently decreases due to manifestation of two imaginary part magnetic permeability dispersions in frequency regions different from each other or a frequency dispersion profile of an imaginary part magnetic permeability that steeply rises and maintains a large value of the imaginary part permeability $\mu$" over a wide frequency band.

On the other hand, consideration will be made of the three samples of the comparative examples. In the sample of the comparative example 1, steep rising is achieved owing to the magnetic resonance but the imaginary part magnetic permeability rapidly decreases after reaching its maximum value. In the sample of the comparative example 2, relaxation dispersion is observed presumably owing to eddy current circulation within the particles. Since rising of the imaginary part magnetic permeability is gentle, this sample is not suitable for suppression of electromagnetic noise that utilizes separation of frequency regions. In the sample of the comparative example 3, two dispersion portions are observed. However, rising is gentle presumably owing to eddy current circulation. Therefore, this sample is inappropriate for separation of frequency regions.

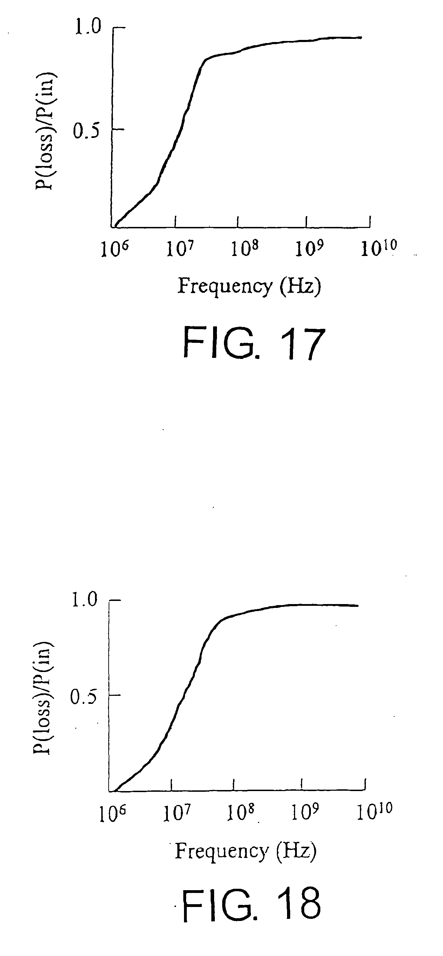

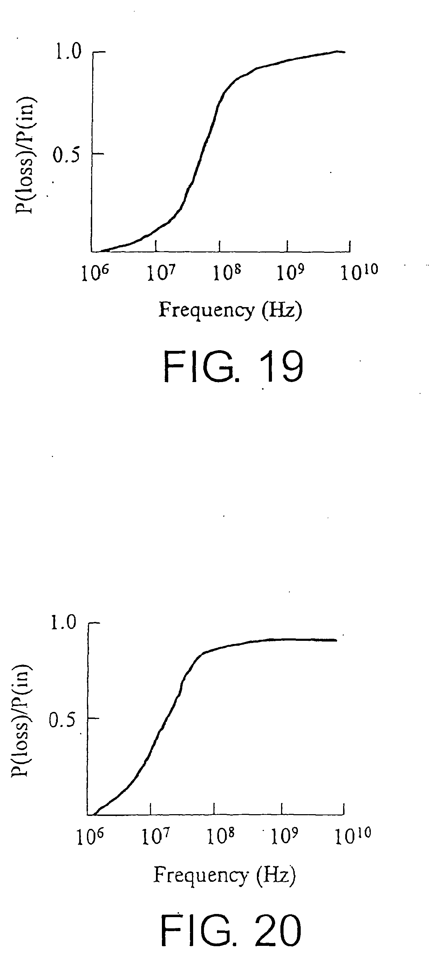

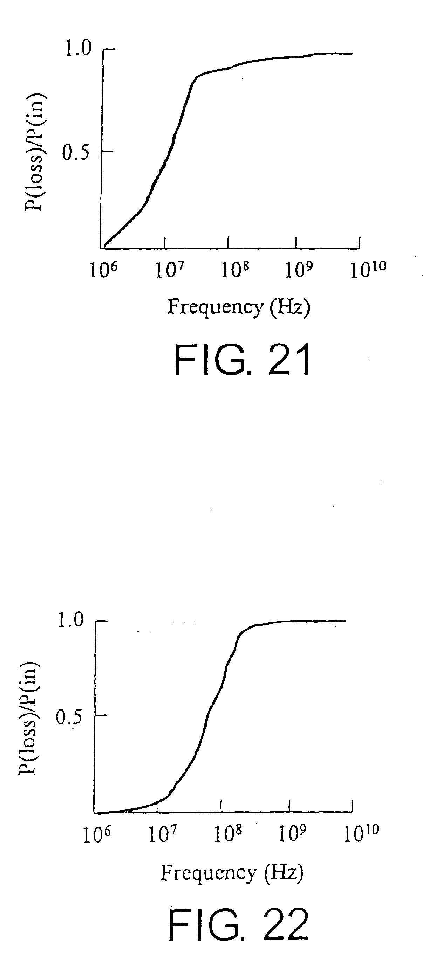

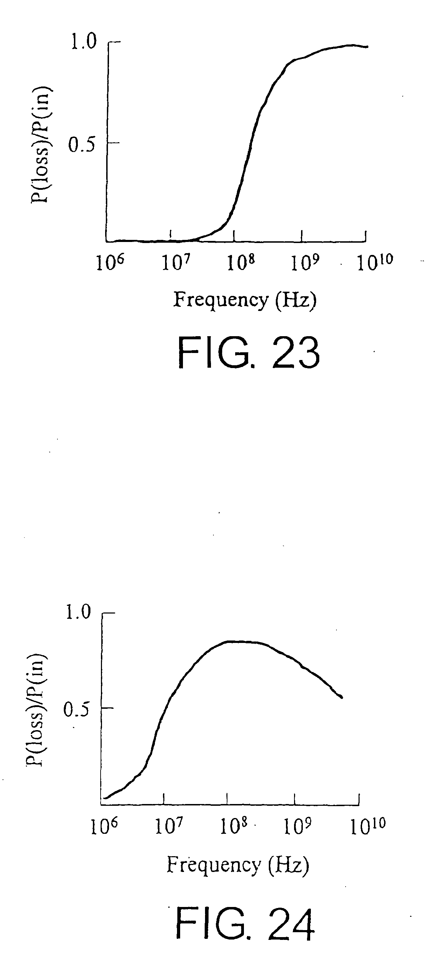

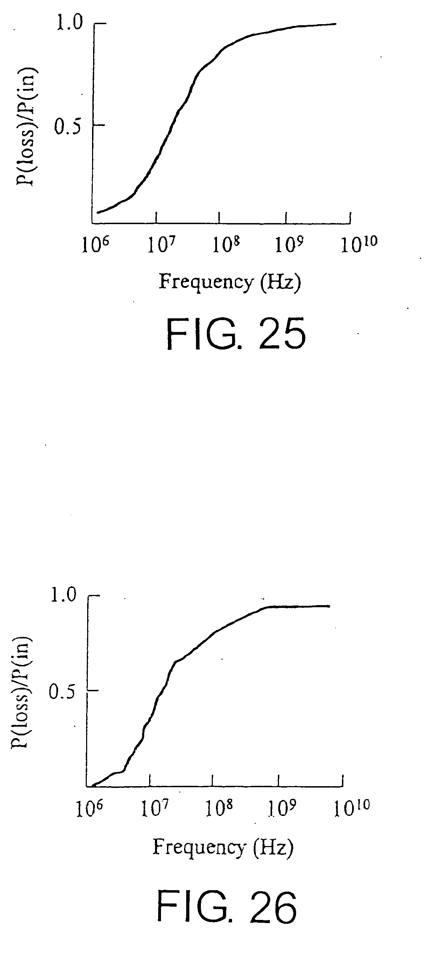

Using the samples of the embodiments and the comparative examples having the imaginary part magnetic permeability dispersions described above, a frequency-dependent characteristic (1 MHz to 10GHz) of a conducted noise suppression effect $P_{loss}$ was actually examined. Figs. 17 to 23 show frequency-dependent characteristics of $P_{loss}$ of the samples of the embodiments 1 to 7, while Figs. 24 to 26 show frequency-dependent characteristics of $P_{loss}$ of the samples of the comparative examples 1 to 3.

From these figures, the effect of the present invention will clearly be seen. Specifically, each of the samples of the embodiments exhibits a frequency characteristic in which $P_{loss}$ representing the degree of conducted noise suppression steeply rises and is less attenuated thereafter, although a frequency region where $P_{loss}$ has large values is different among the samples.

On the other hand, in the sample of the comparative example 1, $P_{loss}$ steeply rises but greatly decreases after reaching its maximum value. In the sample of the comparative example 2, the variation of $P_{loss}$ is moderate. Therefore, this sample is not suitable for separating signal and noise by frequency region. In the sample of the comparative example 3, $P_{loss}$ rises less steeply and, in a certain frequency range higher than about 30MHz, exhibits a gentle curve, as compared with the sample of the embodiment 4 which had a similar B.E.T. specific surface area and which was subjected to heat treatment. Thus, the embodiment 4 is superior.

Typically, a magnetic material that can be used for producing the soft magnetic powder may be a soft magnetic metal material having a large value of the high-frequency permeability, such as silicon steel, an iron-aluminum-silicon alloy (Sendust), an iron-nickel alloy (Permalloy), or an amorphous alloy. The soft magnetic powder may be obtained from the above-mentioned soft magnetic material by grinding, drawing, tearing, atomization-granulation, or the like. As desired, the obtained powder may be further processed into a flat shape by the use of an agitated media mill such as a ball mill. Furthermore, the obtained powder and the flattened powder may be annealed.

Various other soft magnetic materials are also available. For example, it is possible to obtain a desired magnetic loss material by the use of an oxide soft magnetic material, such as spinel ferrite, planar ferrite, hematite, magnetite, or maghematite.

As a binder to be used as a secondary material for obtaining the magnetic loss material, it is advantageous to use chlorinated polyethylene that can achieve excellent flexibility and fire resistance, taking into account the use thereof in the neighborhood of an electronic circuit. Without being limited thereto, however, it is possible to use various organic binders, for example, thermoplastic resin such as polyester resin, polyethylene resin, polyvinyl chloride resin, polyvinyl butyral resin, polyurethane resin, cellulose resin, ABS resin, nitrile-butadiene rubber, styrene-butadiene rubber, or silicone rubber, copolymer thereof, and thermosetting resin such as epoxy resin, phenol resin, amide resin, or imide resin.

No specific limitation is imposed upon a method of mixing and dispersing the magnetic powder and the binder to obtain the magnetic loss material. With reference to the physical properties of the binder to be used and ease of the process, a suitable method may be selected.

The foregoing magnetic loss material has a frequency dispersion profile of the imaginary part magnetic permeability $\mu$" that steeply rises and thereafter gradually decreases or a frequency dispersion of the imaginary part mag-

netic permeability $\mu''$ that steeply rises and maintains a large imaginary part magnetic permeability $\mu''$ over a wide frequency band. Therefore, $P_{loss}$ as an index of a conducted noise suppression effect has a frequency characteristic which steeply rises and is less attenuated thereafter. Accordingly, by the use of the above-mentioned magnetic loss material, it is possible to effectively attenuate a noise component without adversely affecting a signal component. Therefore, the above-mentioned magnetic loss material has an excellent effect of suppressing the radiation of unwanted electromagnetic waves and is highly effective in preventing noise in an electronic component, particularly, a high-speed active element, a high-density printed wiring board, or the like.

**Claims**

1. A magnetic loss material comprising a soft magnetic powder and a binder binding the particles of the powder to one another, the magnetic loss material having a frequency dispersion profile of an imaginary part magnetic permeability ($\mu''$), wherein the frequency dispersion profile comprises at least two different dispersion portions including a first dispersion portion (D1) at a relatively high-frequency side and a second dispersion portion (D2) at a relatively low frequency side, the imaginary part magnetic permeability ($\mu''$) having a first maximum value ($\mu''_{max}$ (D1)) that is the maximum within the first dispersion portion (D1) and a second maximum value ($\mu''_{max}$(D2)) that is the maximum within the second dispersion portion (D2), the second maximum value $\mu''_{max}$ (D2) being equal to or greater than the first maximum value ($\mu''_{max}$ (D1)).

2. The magnetic loss material according to claim 1, wherein the frequency dispersion profile of an imaginary part magnetic permeability ($\mu''$) has the first and the second dispersion portions (D1 and D2) having mutually different dispersion frequency regions, the second dispersion portion (D2) at a low-frequency side is the dispersion owing to magnetic resonance.

3. The magnetic loss material according to claim 1 or 2, wherein the first dispersion portion (D1) at a high-frequency side is the dispersion owing to eddy current or is the dispersion owing to magnetic resonance.

4. The magnetic loss material according to any one of claims 1 to 3, wherein either of relationships of $\Delta fr'' \leq D1_{50}$ or $\Delta fr'' \leq D2_{50}$ is established, where $\Delta fr''$ represents a difference between maximum frequencies ($fr''_{max}$ (D1) and $fr''_{max}$ (D2)) of the first dispersion portion (D1) and the second dispersion portion (D2), $D1_{50}$ represents a full width half maximum of the first dispersion portion (D1), and $D2_{50}$ represents a full width half maximum of the second dispersion portion (D2).

5. The magnetic loss material according to any one of claims 1 to 4, wherein said soft magnetic powder comprises first through (n+1)-th powders which are different from one another in any one of the composition, the particle size, or the particle shape and which are mixed to one another, the imaginary part magnetic permeability ($\mu''$) of said first powder having maximum value ($\mu''_{max}1$) at a first frequency (fr1), the imaginary part magnetic. permeability ($\mu''$) of said (n+1)-th powder having maximum value ($\mu''_{max}(n+1)$) at a (n+1)-th frequency (fr(n+1)), the relationship of fr1 > fr(n+1) being established, and also the relationship of $\mu''_{max}1 < \mu''_{max}(n+1)$ being established, where n is equal to an integer not smaller than one.

6. The magnetic loss material according to any one of claims 1 to 4, wherein said soft magnetic powder has a single kind of composition and a monotonous particle size distribution, and has two anisotropic magnetic fields having mutually different magnitudes.

7. The magnetic loss material according to any one of claims 1 to 4 and 6, wherein said soft magnetic powder is an iron-aluminum-silicon alloy powder of a flat shape, has a specific surface area between $0.5m^2/g$ and $2.0m^2/g$, and is subjected to heat-treatment at a temperature of $500°C$ or more, or wherein said soft magnetic powder is an iron-nickel system alloy powder of a flat shape and has a specific surface area between $0.3m^2/g$ and $0.4m^2/g$, or wherein said soft magnetic powder is a metal-oxide powder of an indefinite shape and has a specific surface area of $1.5m^2/g$ or more.

8. The magnetic loss material according to any one of claims 1 to 4 and 6, wherein said soft magnetic powder comprises a first particle group and a second particle group each of which contains powder particles, the powder particles in said first particle group having a first size greater than a skin depth of said soft magnetic powder, the powder particles in said second particle group having a second size smaller than the skin depth.

9. The magnetic loss material according to claim 8, wherein ones of said powder particles are of an indefinite shape, each of said first and said second sizes being a diameter of each of said ones, or wherein ones of said powder particles are of a flat shape, each of said first and said second sizes being a thickness of each of said ones.

10. The magnetic loss material according to claim 8 or 9, wherein each of said first and said second particle groups is obtained by grinding starting material powder of an indefinite shape having a thickness or a diameter which is greater than the skin depth.

11. The magnetic loss material according any one of claims 8 to 10, wherein the imaginary part magnetic permeability ($\mu''$) owing to the first particle group has a maximum value at a first frequency (fr1), the imaginary part magnetic permeability ($\mu''$) owing to the second particle group has a maximum value at a second frequency (fr2) which is lower than the first frequency (fr1).

12. A method of producing a magnetic loss material in which a frequency dispersion profile of an imaginary part magnetic permeability ($\mu''$) has first and second dispersion portions (D1 and D2) having mutually different dispersion frequency regions, the second dispersion portion (D2) at a low-frequency side being a dispersion owing to magnetic resonance, **characterized in that** said method comprises steps of:

preparing soft magnetic powder of an indefinite shape having a thickness or a diameter which is greater than a skin depth;
grinding said soft magnetic powder to obtain magnetic hybrid soft magnetic powder comprising a first particle group and a second particle group each of which contains powder particles of an indefinite shape or a flat shape, the powder particles in the first particle group having a thickness or a diameter which is greater than said skin depth, the powder particles in the second particle group having a thickness or a diameter which is smaller than said skin depth;
mixing a binder including a high molecular compound into said hybrid soft magnetic powder to obtain a mixture thereof; and
molding said mixture.

FIG. 1

$L_S$ $R_S \fallingdotseq 0$

$C_P$ $G_P \fallingdotseq 0$

Without the test sheet

FIG. 2A

$L_S'$ $R_S'$

$C_P'$ $G_P'$

With the test sheet

FIG. 2B

FIG. 3A

FIG. 3B

15h forged

# FIG. 4

# FIG. 6

Raw granules

$\delta$ s

1                    10                    100

15h forged
powder

1                    10                    100

Powder thickness [ $\mu$ m]

# FIG. 5

FIG. 7

FIG. 8

FIG. 9

FIG. 10

FIG. 11

FIG. 12

FIG. 13

FIG. 14

FIG. 15

FIG. 16

FIG. 17

FIG. 18

FIG. 19

FIG. 20

## FIG. 21

## FIG. 22

FIG. 23

FIG. 24

FIG. 25

FIG. 26